# EUROPEAN PATENT APPLICATION

(11) **EP 4 002 214 A1**
(43) Date of publication of application: **25.05.2022**
(21) Application number: 21207480.1
(22) Date of filing: 10.11.2021
(51) Int. Cl.: G06N 3/00, G06N 3/063, G06N 3/08

(54) **METHOD AND APPARATUS WITH ELECTRONIC MEMORY COPYING OF A NATURAL NEURAL NETWORK**

(30) Priority: 11.11.2020 KR 20200150527; 18.08.2021 KR 20210108472
(71) Applicant: Samsung Electronics Co., Ltd., Suwon-si, Gyeonggi-do 16677 (KR)
(72) Inventor: Donhee, Ham, Suwon-si, Gyeonggi-do 16678 (KR); Sang Joon, Kim, Suwon-si, Gyeonggi-do 16678 (KR)
(74) Representative: Grünecker Patent- und Rechtsanwälte PartG mbB

(57) **Abstract**

Disclosed is an apparatus and method mapping a natural neural network into an electronic neural network device of an electronic device. The method includes constructing a neural network map of a natural neural network based on membrane potentials of a plurality of biological neurons of the natural neural network, where the membrane potentials correspond to at least two different respective forms of membrane potentials, and mapping the neural network map to the electronic neural network device. The constructing of the neural network map and the mapping of the neural network map implement learning of the electronic neural network device. The method may further includes obtaining an input or stimuli, activating the learned electronic neural network device, provided the obtained input or stimuli, to perform neural network operations, and generating a neural network result for the obtained input or stimuli based on a result of the activated learned electronic neural device.

## Description

### BACKGROUND

### 1. Field

The following description relates to a method and apparatus with electronic memory copying of a natural neural network.

### 2. Description of Related Art

Neuromorphic engineering relates to attempts to mimic the network operations of a biological nervous system.

The respective approaches of neuromorphic electronic devices may be divided into natural efforts that attempt to precisely reproduce or mimic the structural operation and function of a natural neural network (NNN), and non-natural efforts that implement an artificial neural network (ANN) having an artificial structure based on a mathematical model trained by machine learning, for example. The natural efforts have typically required the individual considerations of a limited number (e.g., ten) targeted biological neurons to identify a natural neural network, e.g., by using a voltage or patch clamp approach applied to a select biological neuron, or required extracellular macro measurements for the collective observing of the firings of multiple action potentials (APs) of biological neurons of the natural neural network by using extracellular electrodes that generate noisy extracellular measurements of in vitro (dissociated cell culture) or ex vivo (tissue slice) preparations. Typically, such extracellular macro measurements cannot accurately measure or discern other synaptic potentials, such as post-synaptic potentials (PSPs), e.g., due to the extracellular electrodes suffering from low sensitivity, poor registration, mixed signal and signal distortion and/or due to the non-proximate arrangement of the extracellular electrodes with respect to individual neurons, for example. Accordingly, it is very difficult to map individual connections among a large number of biological neurons, and further difficult to map the individual strengths of such connections.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

The object of the present application is solved by the subject matter of the independent claims and preferred embodiments are defined by the dependent claims.

In one general aspect, a method of mapping a natural neural network into an electronic neural network device includes constructing a neural network map of a natural neural network based on membrane potentials of a plurality of biological neurons of the natural neural network, where the membrane potentials correspond to at least two different respective forms of membrane potentials, and mapping the neural network map to the electronic neural network device.

The constructing of the neural network map and the mapping of the neural network map may be achieved based on respective information of first measured membrane potentials interacting with respective information of second measured membrane potentials for respective pre-/post-synaptic relationships among pre-synaptic biological neurons and post-synaptic biological neurons of the natural neural network, and the first measured membrane potentials may correspond to a first form of membrane potential of the at least two different respective forms of membrane potentials, and the second measured membrane potentials may correspond to a different second form of membrane potential of the at least two different respective forms of membrane potentials.

The constructing may include identifying a connection structure among the plurality of biological neurons, and estimating synaptic weights for connections between multiple biological neurons of the plurality of biological neurons.

The estimating of the synaptic weights may be based on a result of the identifying of the connection structure.

The method may further include measuring membrane potentials of the plurality of biological neurons over time, extracting action potentials (APs), of the plurality of biological neurons, from action potential results of the measuring of the membrane potentials, and extracting post-synaptic potentials (PSPs), of the plurality of biological neurons, from post-synaptic potential results of the measuring of the membrane potentials.

The measuring of the membrane potentials of the plurality of biological neurons may include measuring intracellular membrane potentials of the plurality of biological neurons using intracellular electrodes.

The identifying of the connection structure may include identifying the connection structure among the plurality of biological neurons based on respective timings of the APs and respective timings of the PSPs.

The identifying of the connection structure may include determining pre-/post-synaptic relationships among pre-synaptic neurons and post-synaptic neurons of the plurality of biological neurons.

The estimating of the synaptic weights may include estimating the synaptic weights for connections between the pre-synaptic neurons and the post-synaptic neurons based on respective PSPs of the post-synaptic neurons and respective APs of the pre-synaptic neurons.

The mapping may include mapping the plurality of biological neurons to circuit layers of the electronic neural network device, and mapping the synaptic weights and corresponding connectivities among the plurality of biological neurons to memory layers of the electronic neural network device.

The constructing of the neural network map and the mapping of the neural network map may implement learning of the electronic neural network device, where the method may further include obtaining an input or stimuli, activating the learned electronic neural network device, provided the obtained input or stimuli, to perform neural network operations, and generate a neural network result for the obtained input or stimuli based on a result of the activated learned electronic neural device.

In one general aspect, a non-transitory computer-readable storage medium stores instructions that, when executed by a processor, cause the processor to implement or perform one or more or all operations and/or methods described herein.

In one general aspect, a method for generating a neural network result, by an electronic device, using a learned electronic neural network device with learned synaptic connections and synaptic weights having characteristics of the learned electronic neural network device having been mapped from a natural neural network based on respective information of measured action potentials (APs) interacting with respective information of measured post-synaptic potentials (PSPs) for respective pre-/post-synaptic relationships among pre-synaptic biological neurons and post-synaptic biological neurons of the natural neural network, where the method may correspond obtaining an input or stimuli, activating the learned electronic neural network device, provided the obtained input or stimuli, to perform neural network operations, and generate the neural network result for the obtained input or stimuli based on a result of the activated learned electronic neural device.

The method may further include measuring, using first plural electrodes, the APs, measuring, using second plural electrodes, the PSPs, and performing learning of the electronic neural network device by constructing, by the electronic neural network device, a neural network map of the natural neural network based on respective information of the measured APs interacting with respective information of the measured PSPs using corresponding crosslinks of a crossbar.

The first plural electrodes may be different from the second plural electrodes for a respective first timing interval, and some of the first plural electrodes may be same electrodes as some of the second plural electrodes for a respective different second timing interval to measure additional APs or to measure additional PSPs.

In one general aspect, a method of mapping a natural neural network into an electronic neural network device may include considering, using a plurality of neuron modules of the electronic neural network device, at least two different respective forms of membrane potentials measured from a plurality of biological neurons of a natural neural network, and constructing a neural network map in the electronic neural network device, based on the considering, to cause the electronic neural network device to mimic the natural neural network.

The considering may include considering interactions between respective information of measured action potentials (APs) and respective information of measured post-synaptic potentials (PSPs), for respective pre-/post-synaptic relationships among pre-synaptic biological neurons and post-synaptic biological neurons of the natural neural network.

The constructing may include identifying a connection structure among the plurality of neuron modules, and updating synaptic weights for connectivities between different neuron modules of the plurality of neuron modules.

In one general aspect, an electronic neural network device may correspond one or more memory layers configured to store a neural network map, of a natural neural network, for a plurality of neuron modules of the electronic neural network device, one or more circuit layers configured to activate each of multiple neuron modules, of the plurality of neuron modules, in response to a stimuli or an input signal to the electronic neural network device, and perform signal transmissions among the multiple neuron modules, and connectors configured to connect the memory layers and the circuit layers.

A neural network result of the stored neural network map of the natural neural network may be generated dependent on the performing of the signal transmissions.

When the electronic neural network device is a learned electronic neural network device, information in the one or more memory layers and information in the one or more circuit layers may have characteristics of the electronic neural network device having been mapped from the natural neural network based on respective information of measured action potentials (APs) interacting with respective information of measured post-synaptic potentials (PSPs) for respective pre-/post-synaptic relationships among pre-synaptic biological neurons and post-synaptic biological neurons of the natural neural network.

The connectors may include at least one of through-silicon vias (TSVs) penetrating through respective memory layers of the one or more memory layers and respective circuit layers of the one or more circuit layers, and micro bumps connecting the respective memory layers and the respective circuit layers.

A neural network result of the stored neural network map of the natural neural network may be generated dependent on the performing of the signal transmissions, and the circuit layers may be further configured to activate corresponding neuron modules, for the generating of the neural network result, by reading synaptic weights corresponding to connectivities among the corresponding neuron modules from the memory layers in response to the stimuli or input signal.

The one or more memory layers may be one or more crossbar arrays, and respective synaptic weights in the neural network map may be stored in respective crosspoints of the one or more crossbar arrays.

The one or more memory layers and the one or more circuit layers may be three-dimensionally stacked.

In one general aspect, an electronic device includes a processor configured to construct a neural network map of a natural neural network based on membrane potentials of a plurality of biological neurons of the natural neural network, where the membrane potentials correspond to at least two different respective forms of membrane potentials, and map the neural network map to an electronic neural network device of the electronic device.

The processor may be further configured to identify a connection structure among the plurality of biological neurons, and estimate synaptic weights for connections respectively between multiple biological neurons of the plurality of biological neurons.

The processor may be further configured to map the plurality of biological neurons to circuit layers of the electronic neural network device, and map the synaptic weights to memory layers of the electronic neural network device.

The device may further include electrodes measuring membrane potentials of the plurality of biological neurons over time, wherein the processor may be further configured to extract action potentials (APs), of the plurality of biological neurons, from action potential results of the measured membrane potentials, and extract post-synaptic potentials (PSPs), of the plurality of biological neurons, from post-synaptic potential results of the measured membrane potentials.

The constructing of the neural network map and the mapping of the neural network map may be achieved based on respective information of first measured membrane potentials interacting with respective information of second measured membrane potentials for respective pre-/post-synaptic relationships among pre-synaptic biological neurons and post-synaptic biological neurons of the natural neural network, and the first measured membrane potentials may correspond to a first form of membrane potential of the at least two different respective forms of membrane potentials, and the second measured membrane potentials may correspond to a different second form of membrane potential of the at least two different respective forms of membrane potentials.

Other features and aspects will be apparent from the following detailed description, the drawings, and the claims.

### BRIEF DESCRIPTION OF THE DRAWINGS

FIG. 1 illustrates an example of a natural neural network mapping system, according to one or more embodiments.
FIG. 2 is a flowchart illustrating an example of a method of mapping a natural neural network into an electronic neural network, according to one or more embodiments.
FIG. 3 is a flowchart illustrating an example of a method of mapping a natural neural network into an electronic neural network, according to one or more embodiments.
FIG. 4 illustrates an example of a structure of an electronic neural network, according to one or more embodiments.
FIG. 5 illustrates an example of an architecture of a crossbar array, according to one or more embodiments.

Throughout the drawings and the detailed description, unless otherwise described or provided, the same drawing reference numerals will be understood to refer to the same or like elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

Throughout the specification, when a component is described as being "connected to," or "coupled to" another component, it may be directly "connected to," or "coupled to" the other component, or there may be one or more other components intervening therebetween. In contrast, when an element is described as being "directly connected to," or "directly coupled to" another element, there can be no other elements intervening therebetween. Likewise, similar expressions, for example, "between" and "immediately between," and "adjacent to" and "immediately adjacent to," are also to be construed in the same way. As used herein, the term "and/or" includes any one and any combination of any two or more of the associated listed items.

Although terms such as "first," "second," and "third" may be used herein to describe various members, components, regions, layers, or sections, these members, components, regions, layers, or sections are not to be limited by these terms. Rather, these terms are only used to distinguish one member, component, region, layer, or section from another member, component, region, layer, or section. Thus, a first member, component, region, layer, or section referred to in examples described herein may also be referred to as a second member, component, region, layer, or section without departing from the teachings of the examples.

The terminology used herein is for describing various examples only and is not to be used to limit the disclosure. The articles "a," "an," and "the" are intended to include the plural forms as well, unless the context clearly indicates otherwise. The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application, and are not to be interpreted in an idealized or overly formal sense unless expressly so defined herein. The use of the term "may" herein with respect to an example or embodiment (e.g., as to what an example or embodiment may include or implement) means that at least one example or embodiment exists where such a feature is included or implemented, while all examples are not limited thereto.

Examples herein may be, or may be implemented in, various types of products, such as, for example, a personal computer (PC), a laptop computer, a tablet computer, a smart phone, a television (TV), a smart home appliance, an intelligent vehicle, a kiosk, and a wearable device, noting that embodiments are not limited thereto.

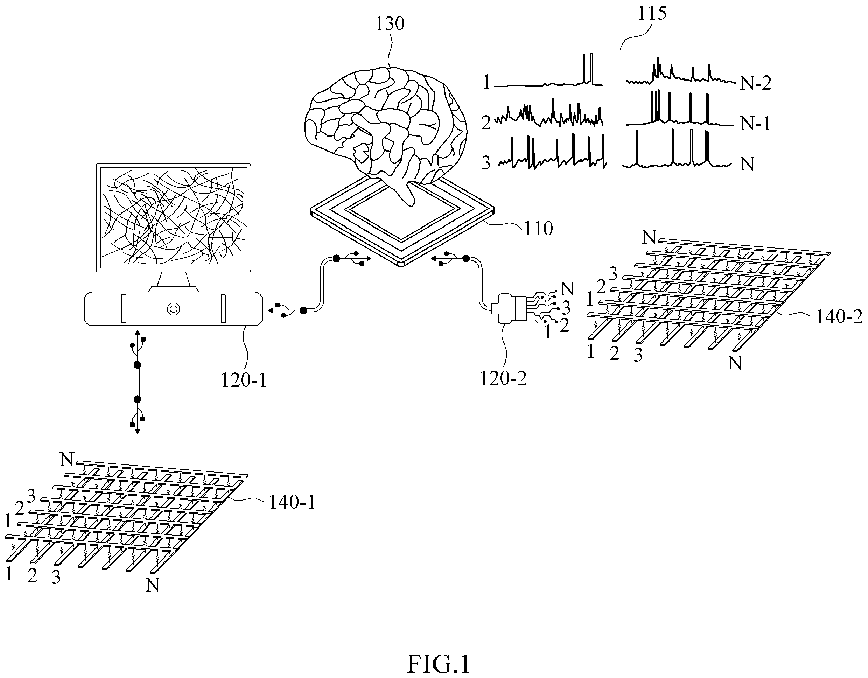

FIG. 1 illustrates an example of a natural neural network mapping system, according to one or more embodiments.

Referring to FIG. 1, a natural neural network mapping system may generate a neural network map that may attempt to perfectly mimic a structure and functions) of a plurality of biological neurons, e.g., biological neurons of a large-scale natural neural network 130 as a non-limiting example, through recording (measurement) or through such recording/measuring and computational analyses of neural signals generated in the biological neurons. For example, the large-scale neural network may be the natural neural network of, or included in, an animal or human brain, a corresponding nervous system, or other large-scale natural neural networks, as non-limiting examples. The natural neural network 130 may be used to configure a neuromorphic processor through a copying of the natural neural network 130, e.g., including biological neuron connection structures and corresponding connection strengths or weightings, to the neuromorphic processor. In one or more embodiments, the configuring of the neuromorphic processor may be directly performed using the measurement results of the corresponding biological neurons, e.g., without computational analyses of measured potentials to discern respective connections between the biological neurons and/or the strength or weightings of such connections. In addition, such measurements of neural signals generated in/by the biological neurons may include different types or forms of membrane potentials, e.g., measured using at least intracellular electrodes, such as through an intracellular electrode interface. Hereinafter, the terms "neural network map", "functional map", and "synaptic connectivity map" may be understood to have the same meaning.

The natural neural network mapping system may include a recording unit 110 for measuring the different types or forms of membrane potentials of each of a plurality of biological neurons of the example large-scale natural neural network 130, e.g., in real time, and mapping devices 120-1 and/or 120-2 for configuring electronic neural networks 140-1 and/or 140-2 to have a same structure as the natural neural network 130.

The electronic neural networks 140-1 and 140-2 may respectively reproduce or mimic biological operations based on the biological neurons of the natural neural network 130. For example, in examples where the electronic neural networks 140-1 and/or 140-2 (that have been copied the structure of the natural neural network 130) may be subsequently implemented based on input information or stimuli, the result or function of such implementations of the electronic neural networks 140-1 and/or 140-2 may be the same or substantially the same as if the biological neurons of the natural neural network 130 had reacted to the same stimuli. Herein, the references to biological neurons are references to living nerve cells, for example, and not artificial neurons. In addition, hereinafter, the term "neuron" or "neurons" by themselves and the terms "nerve cell" and "nerve cells" by themselves may be understood to have the same meaning of such biological neurons. Further, operations that are based on the biological neurons may include, for example, synaptic connection analyses, ion channel analyses, ion channel current measurements, and/or measurements of effects of drugs on neural network connections and dynamics. However, examples are not limited thereto.

The recording unit 110 may include an electrode layer including a plurality of electrodes, e.g., intracellular electrodes, that may be in contact with the biological neurons through the electrodes to respectively record (or measure) neural signals generated in the biological neurons and/or to respectively inject (or provide) stimulation signals to the biological neurons.

For example, through use of the plurality of electrodes, the recording unit 110 may read electrical activities 115 of all the individual biological neurons of the natural neural network 130 that are respectively in contact with at least one of the electrodes, e.g., in real time, using complementary metal-oxide-semiconductor (CMOS) nanoelectrode array (CNEA) technology.

The electrodes of the recording unit 110 may independently connect to the individual biological neurons to simultaneously perform respective recording and measuring for the membrane potentials of each of a plurality of the biological neurons of the natural neural network 130.

For example, in a biological neuron, a potential across the membrane of a biological neuron may typically have a resting membrane potential, e.g., approximately -70mV. The membrane potential may be caused/stimulated to increase or decrease, such as dependent on respective receptions of neurotransmitters by the biological neuron from another biological neuron that can cause or affect exchanges of ions across the neuron membrane, for example, which in turn results in the changes in the membrane potential. When the changing membrane potential meets a certain threshold, e.g., approximately -45mV, due to an example cascading change of the membrane potential from the resting membrane potential, the biological neuron may generate an action potential (AP), also known as "nerve impulses" or "spikes", where the emitting of the AP toward an axon terminal of the biological neuron may also be referred to as the biological neuron "firing." In response to the AP, the biological neuron may release the aforementioned neurotransmitters. Here, the biological neuron that releases the neurotransmitters may be referred to as a pre-synaptic neuron, and a subsequent neuron that receives the neural transmitters may be referred to as a post-synaptic neuron. The reception of the neurotransmitters by the post-synaptic neuron may also be reflected in a change in the membrane potential of the post-synaptic neuron, which may be referred to as a post-synaptic potential (PSP) of the post-synaptic neuron. APs and PSPs are thus different forms or types of membrane potentials. Accordingly, dependent on neurotransmitters received by the post-synaptic neuron from the pre-synaptic neuron, for example, as well as those received from other pre-synaptic neurons by the post-synaptic neuron, for example, the membrane potential of the post-synaptic neuron may repeatedly meet the aforementioned threshold and generate respective APs in the post-synaptic neuron. A temporal sequence of such APs generated by a biological neuron may also be called its "spike train." For example, the timing and frequency of such impulses or spikes of the pre-synaptic neuron's AP may represent the intensity of generated AP of the pre-synaptic neuron, and the timing and frequency of such impulses or spikes of the post-synaptic neuron's AP may represent the intensity of generated AP of the post-synaptic neuron. Accordingly, as a non-limiting example, a connection weighting or strength between the pre-synaptic neuron and the post-synaptic neuron may be demonstrated by a determined relationship between a pre-synaptic neuron's AP and the post-synaptic neuron's PSP. Here, while the above explanation is with respect to a general neuron pre-/post-synaptic relationship with respect to such respective different forms or types of the membrane potentials, e.g., the AP and PSP neuron signals, the above discussion is only an example, as the disclosure herein is also applicable to other neuron types having different operations with respect to the connection between pre-synaptic neuron(s) and post-synaptic neuron(s) for such information sharing between the pre-synaptic neuron and the post-synaptic neuron measurable by intercellular electrodes, for example.

Returning to FIG. 1, the large volume of measured data may be used to construct a neural map, such as through separate signal processing and analyses by the mapping device 120-1, and the neural map may be mapped/copied to the electronic neural network 140-1, e.g., mapped/copied to the electronic neural network 140-1 so as to have same synaptic connections and synaptic weights as the natural neural network 130.

Alternatively, the large volume of measured data may be directly obtained, transmitted, provided, or received, e.g., in real time, to/by the mapping device 120-2 that is configured to directly map/copy the synaptic connections and the synaptic weights of the natural neural network 130 to the electronic neural network 140-2 dependent on the natural electrical activities between adjacent (i.e., pre-/post-synaptic relationship) biological neurons of the natural neural network 130.

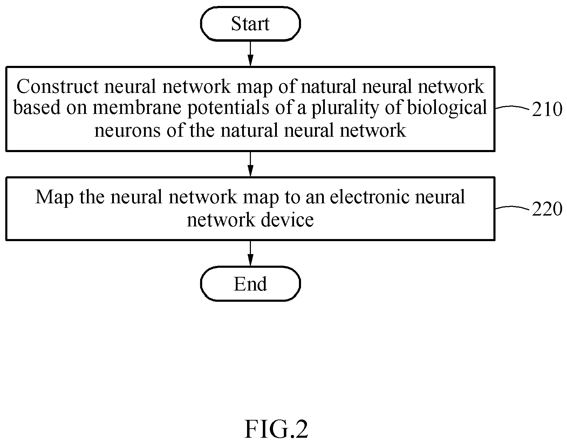

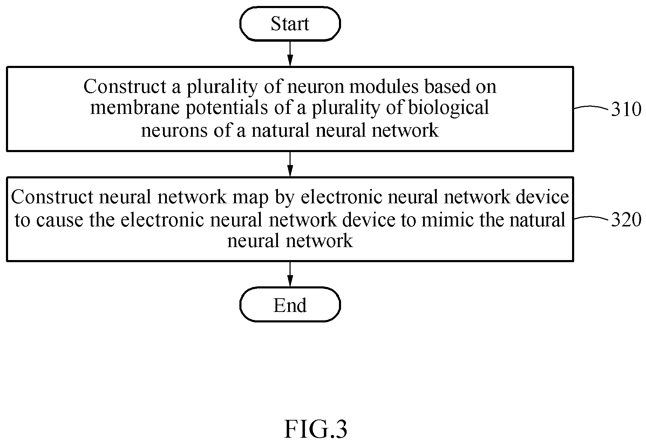

Hereinafter, an example operation of constructing a neural network map of a natural neural network through separate signal processing and copying of the constructed neural network map to an electronic neural network 140-1 will be described with reference to FIG. 2, and an example operation of directly transmitting or providing, for example, the extracted/measured neural signals of a natural neural network to an electronic neural network 140-2 and using the electronic neural network 140-2 to construct and map/copy the neural network map of the natural neural network by itself will be described with reference to FIG. 3.

FIG. 2 is a flowchart illustrating an example of a method of mapping a natural neural network into an electronic neural network, e.g., into a solid-state electronic memory network and circuitry, as a non-limiting example, according to one or more embodiments.

A natural neural network mapping method may be performed by the mapping device 120-1 described above with reference to FIG. 1. The mapping device 120-1 may be implemented by one or more hardware components, may be implemented by one or more processors configured to implement the mapping method based on execution of instructions by the one or more processors, or may be implemented by a combination of the same. Also, the mapping device 120-1 may be included in an example electronic device with the electronic neural network 140-1 (electronic neural network device 140-1), or may be a separate external device (for example, a personal computer) that includes or is separated from the electronic neural network 140-1. The example electronic device may also include or not include the mapping device 120-2 and the electronic neural network 140-2 (electronic neural network device 140-2), discussed in greater detail further below with respect to FIG. 3. Further, the example electronic device may alternatively include the mapping device 120-2 and the electronic neural network 140-2, and not include the mapping device 120-1 and electronic neural network 140-1. Still further, examples include electronic devices that include either or both of the electronic neural networks 140-1, 140-2 that perform such neural network mapping of the respective electronic neural networks 140-1, 140-2, and/or are configured to implement either or both of the electronic neural networks 140-1, 140-2 including the respectively mapped neural networks with respect to input information to artificially perform the natural operations and functions of the correspondingly mapped natural neural network for same input information. References to electronic neural networks may also correspond to such an electronic device, which may also or alternatively include one or more, recording units and/or mapping devices, as well as remaining additional hardware components configured to perform one or more or all functions of such above noted example various types of electronic devices, such as, for example, the personal computer (PC), the laptop computer, the tablet computer, the smart phone, the television (TV), the smart home appliance, the intelligent vehicle, the kiosk, and the wearable device.

Returning to FIG. 2, the mapping device 120-1 may construct a neural network map by analyzing collected data of a natural neural network and then mapping the electronic neural network 140-1 to have a same configuration as the natural neural network. If the natural neural network map is accurately mapped to the electronic neural network 140-1, individual weight values or connection strengths of the electronic neural network 140-1 may accurately represent a corresponding natural weighting or connection strength of the natural connections between the biological neurons of the natural neural network.

Referring to FIG. 2, in operation 210, the mapping device 120-1 constructs a neural network map of a natural neural network based on membrane potentials of a plurality of biological neurons of the natural neural network. The mapping device 120-1 may extract action potentials (APs) and post-synaptic potentials (PSPs), i.e., as respective different forms (types) of neuron signals of corresponding biological neurons, from the membrane potentials. Extraction of the APs and PSPs may also, or alternatively, be performed prior to operation 210 of the mapping device 120-1, e.g., by example circuitry of the recording unit 110.

The mapping device 120-1 may first identify respective connection structures between any neuron(s) of the plurality of biological neurons and any other neuron(s) of the plurality of biological neurons based on the respectively received/measured membrane potentials. Identifying the respective connection structures may include identifying a pre-/post-synaptic relationship (i.e., respective pre-synaptic neurons and post-synaptic neurons) between the biological neurons.

More specifically, the mapping device 120-1 may discriminate adjacent cells by analyzing relationships between the measured PSPs and APs of the biological neurons. For example, when time intervals between APs of a first biological neuron and PSPs of a second biological neuron respectively meet a threshold interval, e.g., are less than or equal to the threshold interval, and such time intervals meeting the threshold interval occur consecutively at a predetermined or higher level or occurrence number/rate, the mapping device 120-1 may determine that the first biological neuron and the second biological neuron are matched and thus have a pre-/post-synaptic relationship. Accordingly, the first biological neuron may be considered the pre-synaptic neuron and the matching second biological neuron may be considered the post-synaptic neuron of this pre-/post-synaptic relationship. The first biological neuron may also have one or more other respective pre-/post-synaptic relationships where the first biological neuron may be considered the pre-synaptic neuron and other matched biological neurons may be considered to be the respective post-synaptic neurons. Likewise, the second biological neuron may also have one or more other respective pre-/post-synaptic relationships where the second biological neuron may be considered the post-synaptic neuron and other matched biological neurons may be considered to be the respective pre-synaptic neurons. The first biological neuron may also be determined to be a post-synaptic neuron with respect to respective pre-/post-synaptic relationships with one or more matched pre-synaptic neurons, and the second biological neuron may also be determined to be a pre-synaptic neuron with respect to respective pre-/post-synaptic relationships with one or more matched post-synaptic neurons. Briefly, while these adjacent cells and corresponding potential pre-/post-synaptic relationships among biological neurons of a natural neural network are discussed with respect to the operations of FIG. 2, e.g., in the context of the mapping device 120-1 and the electronic neural network 140-1, such a discussion is also applicable to the performed/achieved discrimination of adjacent cells and corresponding performed/achieved pre-/post-synaptic relationships among biological neurons of this or another natural neural network discussed below with respect to the operations of FIG. 3, e.g., in the context of the mapping device 120-2 and the corresponding electronic neural network 140-2, and the corresponding learning of the pre-/post synaptic relationships and corresponding synaptic weights.

After identifying the connection structures between each, or a plurality, of such matched pre-/post-synaptic relationship biological neurons of the corresponding natural neural network, the mapping device 120-1 may estimate the corresponding respective synaptic connection strengths or weightings, referred to herein as respective synaptic weights, between each of the biological neuron matchings, i.e., between each of the determined pre-/post-synaptic relationships.

For example, the mapping device 120-1 may set a reference post-synaptic biological neuron, and when a PSP of the reference post-synaptic biological neuron occurs (is measured), estimate synaptic weights between one or more determined pre-synaptic biological neurons that have pre-/post-synaptic relationships with the reference post-synaptic biological neuron. The estimating of these synaptic weights may be performed through analyses of correlations in the PSP and the one or more APs of the one or more pre-synaptic biological neurons. For example, the analyses may include consideration of the amplitude of the PSP and intensities (amplitudes) of APs of the pre-synaptic biological neurons. An intensity of an AP of each biological neuron may be a relative unit of measure dependent on the timing and frequency of the AP by the biological neuron, e.g., a first AP of a first biological neuron may have a determined higher intensity corresponding to an earlier timing and/or faster frequency of the first AP than a determined intensity of a second AP of a second biological neuron corresponding to a delayed timing and/or lower frequency of the second AP. As another example, the respective intensities of the APs (i.e., of respective spike trains) of the pre-synaptic biological neurons may be determined by summing of the respective APs measured from each of the pre-synaptic biological neurons, where a higher summed AP result for one pre-synaptic biological neuron connected to the post-synaptic biological neuron would represent a greater intensity, and a lower summed AP result for another pre-synaptic biological neuron would represent a lower intensity, of the corresponding pre-/post-synaptic relationship. Herein, a reference to an amplitude of an AP of a biological neuron may be understood to refer to any or all such considerations of the intensity of the AP of the biological neuron. For example, the mapping device 120-1 may estimate the synaptic weights based on the amplitude of the PSP of the post-synaptic reference biological neuron and the respective amplitudes of APs of n pre-synaptic biological neurons connected to the reference post-synaptic biological neuron. Thus, the neural network map of the natural neural network may be generated based on the determined pre-/post-synaptic relationships in the natural neural network, and may include the respectively estimated synaptic weights for one or more, or each, of these pre-/post-synaptic relationship biological neuron connections in the natural neural network.

In operation 220, the mapping device 120-1 maps the neural network map to the electronic neural network 140-1. The mapping device 120-1 may combine the neural network map constructed based on the membrane potentials of the biological neurons in operation 210, in the electronic neural network 140-1 with the same configuration as the natural neural network.

As will be described in further detail below, the electronic neural network 140-1 may include one or more memory layers for storing the mapped synaptic weights and one or more circuit layers for performing operations of the biological neurons using the appropriate mapped synaptic weights stored in the memory layer(s) for each corresponding determined pre-/post-synaptic relationship connection. Accordingly, the mapping device 120-1 may map the plurality of biological neurons to the one or more circuit layers of the electronic neural network 140-1 and map the corresponding synaptic weights to the one or more memory layers of the electronic neural network 140-1.

FIG. 3 is a flowchart illustrating an example of a method of mapping a natural neural network into an electronic neural network, e.g., into a solid-state electronic memory network and circuitry, as a non-limiting example, according to one or more embodiments.

A natural neural network mapping method may be performed by the natural neural network mapping system described above with reference to FIG. 1, for example. The recording unit 110, the mapping device 120-2, and the electronic neural network 140-2 may be implemented by one or more hardware components, may be implemented based on a combination of the hardware components and one or more processors configured to implement the mapping method based on execution of instructions by one or more processors, or may be implemented by a combination of the same.

The mapping device 120-2 may map synaptic weights of a natural neural network by directly transmitting or providing measured/read membrane potentials of the natural neural network, e.g., measured in real time, to the electronic neural network 140-2. The electronic neural network 140-2 may learn pre-/post-synaptic relationships, as well as the strengths or weightings of each of the pre-/post-synaptic relationship biological neuron connections, based on the membrane potentials collected from the natural neural network. Based on this learning, the electronic neural network 140-2 may duplicate the connection structure of the original natural neural network or mimic behaviors thereof. In an example, the electronic neural network 140-2 mapped through the mapping device 120-2 may mimic a response of a target natural neural network to predetermined stimulus/stimuli based on a learning from only the time-series membrane potential information of some of the biological neurons of the target natural neural network measured/read from the target natural neural network, e.g., without using information related to the number of not-measured neurons other than neurons measured in a target natural neural network and a connectivity between neurons. For example, as 'some' biological neurons of the target natural neural network may not have such a pre-/post-synaptic connection relationship, e.g., a corresponding measured AP from one biological neuron may not match with a measured PSP of another biological neuron and thus these AP and PSP measurements would not affect the electronic neural network 140-2 to learn of such a non-connection between such 'some' biological neurons, the corresponding portions of the electronic neural network 140-2 may not be learned or include synaptic weight information. For example, the corresponding synaptic weight information in the electronic neural network 140-2 for such 'some' biological neurons may have a zero value at a corresponding portion (e.g., memory element) of the electronic neural network 140-2.

Referring to FIG. 3, in operation 310, the mapping device 120-2 transmits or provides measured/read membrane potentials, of a plurality of biological neurons that make up a natural neural network, to the electronic neural network 140-2 which includes a plurality of neuron modules, e.g., as a physical or virtual neuron representation provided by the hardware of a processor and/or corresponding circuit layer of the electronic neural network 140-2. Each of plural neuron modules of the electronic neural network 140-2 may thus correspond to a corresponding biological neuron of the natural neural network.

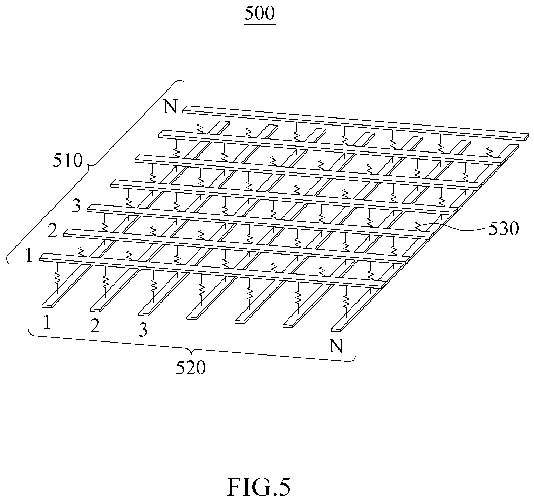

In operation 320, based on the transmitted or provided measured/read membrane potentials, the electronic neural network 140-2 constructs a neural network map during the learning processes of the electronic neural network 140-2 to ultimately mimic the natural neural network. For example, compared to (or in addition to) the operations of FIG. 2, the electronic neural network 140-2 may not construct the neural network map using the separate external device (e.g., without an example separate mapping device 120-1) and without having to perform the analyses of operation 210 of FIG. 2 to identify pre-/post-synaptic relationship biological neurons and for estimating the connection strengths or weightings between the pre-/post-synaptic relationship biological neurons. Rather, the electronic neural network 140-2 may construct the neural network map by itself based on the respective inputs to the electronic neural network 140-2 regarding the measured/read membrane potentials. To this end, the electronic neural network 140-2 may include a processor or other circuitry that constructs the neural network map. As a non-limiting example, the processor may include a crossbar memory structure, e.g., as a memory layer of the electronic neural network 140-2. In an example, the electronic neural network 140-2 may have one or more memory layers and one or more circuit layers. The crossbar memory structure may correspond to the crossbar 510 of FIG. 5, for example.

Constructing the neural network map may include mapping connection structures between the plurality of neuron modules of the electronic neural network 140-2 and setting or updating synaptic weights, between the plurality of neuron modules, in the processor. A neuron module circuit device, e.g., represented by one or more circuit layers of the electronic neural network 140-2, may control the updating of the values of the synaptic weights through spike-timing-dependent plasticity (STDP) learning of the processor.

For example, the electronic neural network 140-2 may be representative of including a pulse converter, e.g., as one of the circuit layers 420 of the electronic neural network 140-2, for converting APs and PSPs signaling of biological neurons into memory writing pulses having a fixed time interval, and may be representative of including a delay converter, e.g., as one of the circuit layers 420 of the electronic neural network 140-2, for adjusting each interval between respective pulses in inverse proportion to the amplitudes of the PSPs. Furthermore, the extracted AP and PSP pulses may be transmitted/input to the processor to respectively adjust a conductance of a target crosspoint of the processor, e.g., a crosspoint of the crossbar 510 of FIG. 5.

The electronic neural network may change or update the values of the synaptic weights between the neuron modules through STDP learning. In one or more embodiments, the electronic neural network may map connection strengths according to the STDP properties of a resistive random-access memory (RRAM) by mapping the connection strength between two neuron modules to increase as the time interval between the AP and PSP of the two connected neuron modules decreases.

Depending on the implementation, the synaptic weights may be changed or updated by a predetermined value through a simple comparator or may be selected from several values according to a difference in firing timing through a look-up table (LUT) scheme using a corresponding LUT stored in any memory of the electronic neural network, the neural network mapping system, or the electronic device. For example, the weight updates for the synaptic modules may occur by themselves based on the respective sharing of information between adjacent neuron modules, e.g., based on the respective characteristics of the AP and PSP neural signals for each natural pre-/post-synaptic relationship. The values of the synaptic weights may be updated in various other approaches, and thus, examples are not limited to the above-described synaptic weight updating approach.

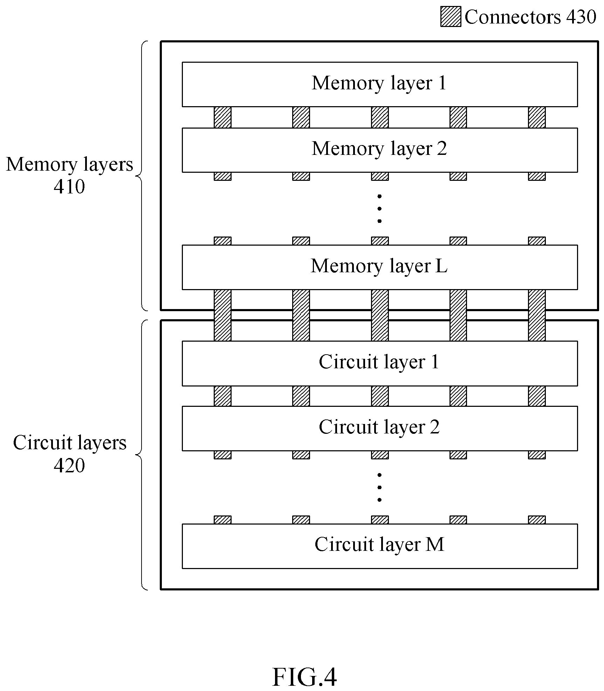

FIG. 4 illustrates an example of a structure of an electronic neural network, according to one or more embodiments.

Referring to FIG. 4, an electronic neural network may include one or more memory layers 410, one or more circuit layers 420, and connectors 430. The description provided with reference to FIGS. 1 to 3 may apply to the example of FIG. 4, and the electronic neural network of FIG. 4 may also correspond to the electronic neural networks of FIGS. 1-3, and thus, duplicate descriptions will be omitted for ease of description.

The memory layers 410 may store a neural network map of a natural neural network. For example, each of the memory layers 410 may store synaptic weights between pre-/post-synaptic relationship biological neurons of the mapped neural network. For example, one of the memory layers 410 may store a synaptic weight between an i-th biological neuron (as a pre-synaptic biological neuron) and a j-th biological neuron (as a corresponding connected post-synaptic biological neuron). Each of the memory layers 410 may similarly store corresponding synaptic weights between respective pre-synaptic biological neurons and post-synaptic biological neurons of corresponding pre-/post synaptic relationships of the natural neural network.

The memory layers 410 may be capable of storing all synaptic weights for each of the pre-/post-synaptic relationship biological neuron connections. As an example, in an example natural neural network that includes N (for example, 10⁹) nerve cells each having K (for example, 1000) synaptic connections, the memory layers 410 may be capable of storing KxN/2 (for example, 1000x 10⁹/2) synaptic weights. An example architecture of a crossbar array that may efficiently store such a large volume of data will be described in greater detail below with reference to FIG. 5 as a non-limiting example of a memory layer 410 of the memory layers 410.

Accordingly, FIG. 5 illustrates an example of an architecture of a crossbar array, according to one or more embodiments.

As demonstrated in FIG. 5, the memory layers, e.g., the memory layers 410 of FIG. 4, may be respectively implemented in an architecture of a crossbar array 500. The crossbar array 500 may include first electrodes 510 provided in a plurality of rows on a substrate, second electrodes 520 provided in a plurality of rows to cross the first electrode 510, and memory elements 530 provided between the first electrodes 510 and the second electrodes 520, the memory elements each having a resistance that changes according to a voltage applied between the corresponding first electrodes 510 and second electrodes 520.

The mapping device 120-1, for example, may map the plurality of biological neurons making up a natural neural network to the first electrodes 510 and the second electrodes 520 and respectively map the respective synaptic weights between each of the biological neurons to the memory elements 530. As a non-limiting example, the mapping device 120-1 may map N biological neurons making up the natural neural network to the first electrodes 510 and the second electrodes 520 provided in their respective N rows, e.g., where both N rows have equal number of rows respectively corresponding to an equal N number of biological neurons. Thereafter, the synaptic weight between the i-th biological neuron and the j-th biological neuron according to the generated neural network map of the natural neural network may be stored in the corresponding memory element 530 positioned at the crosspoint of the first electrode 510 corresponding to the i-th biological neuron and the second electrode 520 corresponding to the j-th biological neuron. In this case, the mapping device 120-1, for example, may store the synaptic weight in the memory element 530 by adjusting a variable resistance value of the memory element 530. A sequential 1 through N rows of the first electrodes 510 may be respectively provided neural signals (e.g., AP neural signals or pulses) from 1 through N biological neurons, alike a sequential 1 through N rows of the second electrodes 520 that may be respectively provided different neural signals (e.g., PSP neural signals or pulses) from the 1 through N biological neurons, though embodiments are not limited to the same. For example., there may be any order of provision of the neural signals among the 1 through N biological neurons to the 1 through N first electrodes 510, which may be alike or different from any order of provision of other neural signals among the 1 through N biological neurons to the 1 through N second electrodes 520.

The crossbar array 500 having an NxN structure may be used to store the synaptic weights between N (for example, 10⁹) biological neurons. However, as described above, since one biological neuron may have many K (for example, 1000) synaptic connections, many areas of the crossbar array 500 having the NxN structure may not be used because the corresponding biological neuron is not connected, e.g., not at all or determined not sufficiently connected, to another biological neuron in the natural neural network. In one or more embodiments, since the mapping device 120-1, for example, knows the relationships between actually connected biological neurons through the already generated neural network map, the crossbar array 500 may store only synaptic weights that exist for the determined pre-/post-synaptic biological neurons and may exclude or avoid having crosspoints representing no or zero value synaptic weights. This may increase the efficiency of memory layers.

However, the architecture of the memory layers 410 is not necessarily limited to the crossbar array 500.

Referring back to FIG. 4, the circuit layers 420 may activate each of the plurality of neuron modules in response to a reception of a signal and perform signal transmission/provision between the plurality of neuron modules.

The circuit layers 420 may include stacked circuits, and the stacked circuits may be circuits configured to perform functions such as, for example, the aforementioned neural signal measurements, signal processing, analyses, and/or any other operations discussed herein, e.g., to work in cooperation with the one or more memory layers 410 that may store the synaptic weights. The circuits having the above-mentioned functions may be distributed in a number of circuit layers or integrated in one circuit layer. The circuits may be, for example, CMOS integrated circuits (ICs). However, examples are not necessarily limited thereto. To copy the connection structure of a large-scale natural neural network, e.g., with many biological neurons, an electronic neural network structure of the same or like size as the natural neural network may be used. For example, the electronic neural network may be a 3D stacked system, which may increase the degree of integration between layers.

For example, the memory layers 410 may include, for example, a memory layer 1, a memory layer 2, ..., and a memory layer L. The memory layers may be vertically stacked on each other, for example.

Similarly, the circuit layers 420 may include, for example, a circuit layer 1, a circuit layer 2, ..., and a circuit layer M. The circuit layers may be vertically stacked on each other, for example. Each of the circuit layers may include a circuit for performing a different function or operation. For example, the circuit layer 1 may include circuitry for performing accumulations, the circuit layer 2 may include circuitry for firing, and the circuit layer M may include circuitry for voltage amplification.

Alternatively, each of the circuit layers may include circuits for performing the same functions or operations. For example, the circuit layer 1 may include a circuit for accumulation and a circuit for firing, and the circuit layer 2 may also include a circuit for accumulation and a circuit for firing, like the circuit layer 1.

The connectors 430 may connect the memory layers 410 and the circuit layers 420. The connectors 430 may be, for example, at least one of through-silicon vias (TSVs) penetrating through the memory layers 410 and the circuit layers 420 and micro bumps connecting the memory layers 410 and the circuit layers 420.

TSV is a packaging technique for drilling fine vias in chips and filling the vias with conductive materials to connect upper chips and lower chips, rather than connecting the chips using wires. Since the TSVs may secure direct electrical connection paths in the chips and thus, use less space than previous non-TSV packaging, the package size may be reduced, and the length of interconnection between the chips may be reduced.

In response to a reception of a stimulus signal, the circuit layers 420 may read synaptic weights corresponding to connected neuron modules from the memory layers 410 storing the synaptic weights and activate the neuron modules. In this case, the connectors 430 may perform signal transmission between the memory layers 410 and the circuit layers 420.

According to examples, a natural neural network mapping apparatus may include a processor or other circuitry that receives membrane potentials of a plurality of biological neurons making up a natural neural network, constructs a neural network map of the natural neural network based on the membrane potentials, and maps the neural network map to an electronic neural network.

The processor or other circuitry, e.g., of a corresponding electronic device, may identify respective connection structures between the plurality of biological neurons and estimate synaptic weights between those biological neurons for which connection structures are identified.

The processor or other circuitry, e.g., of a/the corresponding electronic device, may map the plurality of biological neurons to circuit layers of the electronic neural network, and map the synaptic weights to memory layers of the electronic neural network. The electronic device may implement the mapped neurons and synaptic weights to artificially implement the same functions as the measured biological neurons of the original biological neural network.

The neural network mapping systems, electronic devices, mapping devices, electronic neural network, electronic neural network devices, recording units, membrane potential recording/measuring electrodes, signal and/or analysis processors, processors, neuromorphic processors, crossbars, memory elements, resistive random-access memory, memory layers, circuit layers, circuitry for performing accumulations, circuitry for firing, circuitry for voltage amplification, CMOS integrated circuits (ICs), 3D stacked systems, 3D vertically stacked systems, neuron modules, electrodes, complementary metal-oxide-semiconductor (CMOS) nanoelectrode arrays, solid-state electronic memory networks and/or circuitry, as non-limiting examples, and other apparatuses, devices, modules, elements, and components described herein with respect to FIGS. 1-5 are implemented by hardware components. Examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. A hardware component may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 1-5 that perform the operations described in this application are performed by computing hardware, for example, by one or more processors or computers, implemented as described above executing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions used herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media. Examples of a non-transitory computer-readable storage medium include read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD-Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks, and any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

## Claims

1. A method of mapping a natural neural network into an electronic neural network device, the method comprising:
constructing a neural network map of a natural neural network based on membrane potentials of a plurality of biological neurons of the natural neural network, where the membrane potentials correspond to at least two different respective forms of membrane potentials; and
mapping the neural network map to the electronic neural network device.

2. The method of claim 1,
wherein the constructing of the neural network map and the mapping of the neural network map are achieved based on respective information of first measured membrane potentials interacting with respective information of second measured membrane potentials for respective pre-/post-synaptic relationships among pre-synaptic biological neurons and post-synaptic biological neurons of the natural neural network, and
wherein the first measured membrane potentials corresponds to a first form of membrane potential of the at least two different respective forms of membrane potentials, and the second measured membrane potentials corresponds to a different second form of membrane potential of the at least two different respective forms of membrane potentials.

3. The method of claim 1 or 2, wherein the constructing comprises:
identifying a connection structure among the plurality of biological neurons; and
estimating synaptic weights for connections between multiple biological neurons of the plurality of biological neurons.

4. The method of claim 3, wherein the estimating of the synaptic weights is based on a result of the identifying of the connection structure, or
further comprising measuring membrane potentials of the plurality of biological neurons over time; extracting action potentials ,APs, of the plurality of biological neurons, from action potential results of the measuring of the membrane potentials; and extracting post-synaptic potentials, PSPs, of the plurality of biological neurons, from post-synaptic potential results of the measuring of the membrane potentials, or
wherein the mapping comprises mapping the plurality of biological neurons to circuit layers of the electronic neural network device; and mapping the synaptic weights and corresponding connectivities among the plurality of biological neurons to memory layers of the electronic neural network device.

5. The method of claim 4, wherein the measuring of the membrane potentials of the plurality of biological neurons includes measuring intracellular membrane potentials of the plurality of biological neurons using intracellular electrodes, or
wherein the identifying of the connection structure comprises identifying the connection structure among the plurality of biological neurons based on respective timings of the APs and respective timings of the PSPs.

6. The method of claim 3, wherein the identifying of the connection structure comprises determining pre-/post-synaptic relationships among pre-synaptic neurons and post-synaptic neurons of the plurality of biological neurons, and
wherein the estimating of the synaptic weights comprises estimating the synaptic weights for connections between the pre-synaptic neurons and the post-synaptic neurons based on respective PSPs of the post-synaptic neurons and respective APs of the pre-synaptic neurons.

7. The method of one of claims 1 to 6, wherein the constructing of the neural network map and the mapping of the neural network map implement learning of the electronic neural network device, and
wherein the method further comprises:
obtaining an input or stimuli;
activating the learned electronic neural network device, provided the obtained input or stimuli, to perform neural network operations; and
generating a neural network result for the obtained input or stimuli based on a result of the activated learned electronic neural device.

8. A method for generating a neural network result, by an electronic device, using a learned electronic neural network device with learned synaptic connections and synaptic weights having characteristics of the learned electronic neural network device having been mapped from a natural neural network based on respective information of measured action potentials, APs, interacting with respective information of measured post-synaptic potentials, PSPs, for respective pre-/post-synaptic relationships among pre-synaptic biological neurons and post-synaptic biological neurons of the natural neural network, the method comprising:
obtaining an input or stimuli;
activating the learned electronic neural network device, provided the obtained input or stimuli, to perform neural network operations; and
generate the neural network result for the obtained input or stimuli based on a result of the activated learned electronic neural device.

9. The method of claim 8, further comprising:
measuring, using first plural electrodes, the APs;
measuring, using second plural electrodes, the PSPs; and
performing learning of the electronic neural network device by constructing, by the electronic neural network device, a neural network map of the natural neural network based on respective information of the measured APs interacting with respective information of the measured PSPs using corresponding crosslinks of a crossbar, and
wherein the first plural electrodes are different from the second plural electrodes for a respective first timing interval, and some of the first plural electrodes are same electrodes as some of the second plural electrodes for a respective different second timing interval to measure additional APs or to measure additional PSPs.

10. A non-transitory computer-readable storage medium storing instructions that, when executed by a processor, cause the processor to implement the method of mapping a natural neural network into an electronic neural network device, the method comprising:
considering, using a plurality of neuron modules of the electronic neural network device, at least two different respective forms of membrane potentials measured from a plurality of biological neurons of a natural neural network; and
constructing a neural network map in the electronic neural network device, based on the considering, to cause the electronic neural network device to mimic the natural neural network.

11. The computer-readable storage medium of claim 10, wherein the considering includes considering interactions between respective information of measured action potentials, APs, and respective information of measured post-synaptic potentials, PSPs, for respective pre-/post-synaptic relationships among pre-synaptic biological neurons and post-synaptic biological neurons of the natural neural network, or
wherein the constructing comprises:
identifying a connection structure among the plurality of neuron modules; and
updating synaptic weights for connectivities between different neuron modules of the plurality of neuron modules.

12. An electronic neural network device, comprising:
one or more memory layers configured to store a neural network map, of a natural neural network, for a plurality of neuron modules of the electronic neural network device;
one or more circuit layers configured to activate each of multiple neuron modules, of the plurality of neuron modules, in response to a stimuli or an input signal to the electronic neural network device, and perform signal transmissions among the multiple neuron modules; and
connectors configured to connect the memory layers and the circuit layers.

13. The electronic neural network device of claim 12, wherein a neural network result of the stored neural network map of the natural neural network is generated dependent on the performing of the signal transmissions, or
wherein, when the electronic neural network device is a learned electronic neural network device, information in the one or more memory layers and information in the one or more circuit layers have characteristics of the electronic neural network device having been mapped from the natural neural network based on respective information of measured action potentials, APs, interacting with respective information of measured post-synaptic potentials, PSPs, for respective pre-/post-synaptic relationships among pre-synaptic biological neurons and post-synaptic biological neurons of the natural neural network.

14. The electronic neural network device of claim 12 or 13, wherein the connectors comprise at least one of through-silicon vias, TSVs, penetrating through respective memory layers of the one or more memory layers and respective circuit layers of the one or more circuit layers; and micro bumps connecting the respective memory layers and the respective circuit layers.

15. The electronic neural network device of one of claims 12 to 14,wherein a neural network result of the stored neural network map of the natural neural network is generated dependent on the performing of the signal transmissions, and wherein the circuit layers are further configured to activate corresponding neuron modules, for the generating of the neural network result, by reading synaptic weights corresponding to connectivities among the corresponding neuron modules from the memory layers in response to the stimuli or input signal, or
wherein the one or more memory layers are one or more crossbar arrays, and wherein respective synaptic weights in the neural network map are stored in respective crosspoints of the one or more crossbar arrays, or
wherein the one or more memory layers and the one or more circuit layers are three-dimensionally stacked.
